# EUROPÄISCHE PATENTSCHRIFT

(11) **EP 0 535 359 B1**
(45) Veröffentlichungstag und Bekanntmachung des Hinweises auf die Patenterteilung: **11.12.1996**
(21) Anmeldenummer: 92114332.7
(22) Anmeldetag: 21.08.1992
(51) Int. Cl.: H03K 5/13

(54) **Analoge Verzögerungsschaltungsanordnung**
Analog delay circuit arrangement
Arrangement de circuit de retard analogique

(30) Priorität: 30.09.1991 DE 4132517
(43) Veröffentlichungstag der Anmeldung: 07.04.1993
(73) Patentinhaber: SIEMENS AKTIENGESELLSCHAFT, 80333 München (DE)
(72) Erfinder: Massoner, Johann, Dipl.-Ing., A 9500 Villach (AT)

(56) Entgegenhaltungen:
- EP-A- 0 236 525
- EP-A- 0 379 169
- EP-A- 0 423 963
- US-A- 5 028 823

## Beschreibung

Die Erfindung betrifft eine analoge Verzögerungsschaltungsanordnung mit einer gesteuerten Stromquelle, deren Strom für den Ladezustand eines Kondensators maßgebend ist, dem eine Schaltstufe nachgeschaltet ist.

Insbesondere in Verbindung mit Anwendungen der Leistungselektronik besteht oft die Notwendigkeit, Verzögerungsschaltungen einzusetzen, die Nutzsignale vor allem bei Schaltvorgängen der Leistungsschalter unterdrücken, um Fehlfunktionen zu verhindern. Sobald der Schaltvorgang des Hochstromschalters abgeschlossen ist, soll die Schaltung im Normalbetrieb ohne zusätzliche Verzögerung arbeiten. Bei Hochstromschaltern, wie sie beispielsweise zunehmend in der Autoelektronik eingesetzt werden, unterscheidet man Schalter, die bezüglich der Last den positiven Versorgungsspannungszweig schalten (High Side Switches) oder die den negativen Versorgungsspannungszweig schalten (Low Side Switches). Entsprechend werden für Schalter auf der positiven Versorgungsspannungsseite p-Kanal-Transistoren und für Schalter auf der negativen Versorgungsspannungsseite n-Kanal-Transistoren eingesetzt.

Insbesondere bei Schaltern auf der Seite der positiven Spannungszuführung werden üblicherweise Ladungspumpen eingesetzt, da die p-Kanal-Transistoren für ein optimiertes Schaltverhalten eine oberhalb der positiven Versorgungsspannung liegende Gatespannung benötigen. Derartige Ladungspumpen erfordern Oszillatorstufen. Auch bei Schaltern auf der Seite des negativen Versorgungsspannungspotentials, für die üblicherweise DMOS-Transistoren eingesetzt werden, ist es oft erforderlich, die Gatespannung möglichst hoch zu wählen, um die Laststrecke möglichst niederohmig zu machen. Für diesen Zweck eignen sich ebenfalls Ladungspumpen.

Je nach Ausführung der Leistungsschalter müssen die Nutzsignale zwischen 1 und 10 ms verzögert oder unterdrückt werden. Üblicherweise werden als Verzögerungsschaltungen entweder Zählerstufen oder Kondensator-Widerstands-Anordnungen mit einer entsprechend gewählten Zeitkonstanten eingesetzt. Beide Lösungen sind in Leistungstechnologien außerordentlich flächenintensiv.

In der europäischen Patentanmeldung EP-A2-0 423 963 ist eine Verzögerungsschaltung gezeigt, bei der ein Ladekondensator an einen Inverter ausgangsseitig angeschlossen ist, in dessen Ausgangskreise zum positiven und negativen Versorgungsspannungsanschluß hin je eine gesteuerte Stromquelle geschaltet ist, durch die jeweils der Lade- oder Entladestrom gesteuert wird. Die Stromquellen werden jeweils über eine Stromspiegelschaltung angesteuert, wobei die Stromspiegelschaltungen miteinander gekoppelt sind.

In der US-Patentschrift US-A-5 028 823 ist eine Verzögerungsschaltung mit getakteter Entladung eines Kondensators gezeigt. Der Ladekondensator ist über eine Diode mit einer Referenzspannungsquelle verbunden, über die er aufladbar ist. Die Referenzspannungsquelle ist ausgangsseitig über einen Schalttransistor, an dem das Eingangssignal mit der zu verzögernden Flanke angelegt wird, mit Masse verbindbar. Der Kondensator wird über einen taktgesteuerten Transistor nach Masse entladen. Zur Taktsteuerung ist ein Oszillator mit ausgeglichenem Tastverhältnis vorgesehen.

Der Erfindung liegt die Aufgabe zugrunde, eine analoge Zeitverzögerungsschaltungsanordnung anzugeben, die einen geringen Halbleiter-Flächenbedarf aufweist.

Diese Aufgabe wird mit den Merkmalen des Patentanspruchs 1 gelöst.

Die Erfindung hat den Vorteil, daß durch die Wahl des Puls-Pausen-Verhältnisses und der Stromspiegelgeometrie der Lade- bzw. Entladestrom des Kondensators entsprechend der gewünschten Verzögerungszeit so eingestellt werden kann, daß auch bei großen Verzögerungszeiten der Kondensator klein und die Transistorflächen minimal sein können.

Ausgestaltungen der Erfindung sind in Unteransprüchen gekennzeichnet.

Die Erfindung wird nachfolgend anhand eines in den Figuren der Zeichnung dargestellten Ausführungsbeispieles näher erläutert. Es zeigt:
- Figur 1: ein Prinzipschaltbild einer erfindungsgemäßen Verzögerungsschaltungsanordnung und
- Figur 2: ein Prinzipschaltbild zur Erzeugung eines Puls-Pausen-Signals.

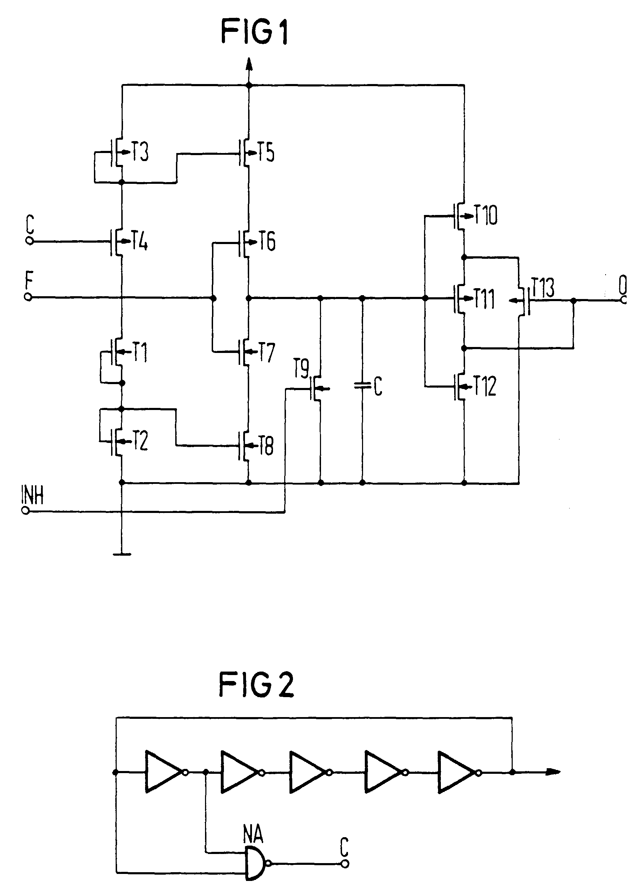

Die Schaltungsanordnung gemäß Figur 1 enthält eine Stromquellenanordnung mit den Transistoren T1 bis T4. Die Ausgangskreise dieser Transistoren sind hintereinander geschaltet und werden von einer Spannungsquelle versorgt. Die eigentliche Stromquelle bildet der Transistor T1, der den durch den Zweig fließenden Strom definiert. T1 ist als MOS-Feldeffekttransistor vom Verarmungstyp ausgeführt. Damit wird der durchfließende Strom unabhängig von der Versorgungsspannung. Es ist klar, daß auch andere Realisierungsformen der Stromquelle eingesetzt werden können, z.B. ein hochohmiger Widerstand oder ein entsprechend geschalteter Transistor vom Anreicherungstyp. Der in Reihe zum Transistor T1 liegende Transistor T4 ist für die Taktung der Stromquelle verantwortlich. Dazu wird der Gateanschluß des Transistors T4 von einem Taktsignal angesteuert, das an die Klemme C angelegt wird. Es ist vorgesehen, daß das Taktsignal ein Puls-Pausen-Verhältnis unter 1 aufweist, beispielsweise kleiner als 1:10. Damit wird sichergestellt, daß nur zu bestimmten Zeiten der vom Transistor T1 definierte Strom durch den Zweig fließen kann. Im Ausführungsbeispiel ist T4 als p-Kanal-Transistor ausgeführt.

Ein Taktsignal zur Ansteuerung des Transistors T4 kann beispielsweise mit einer Schaltung gemäß Figur 2 erzeugt werden. Diese enthält eine Kette nicht bezeichneter Inverter, deren Ausgang auf den Eingang rückgekoppelt ist. Damit wird eine Oszillatorstufe realisiert, die ausgangsseitig zu einer Ladungspumpe führen kann. Das Eingangs- und Ausgangssignal eines Inverters bilden die Eingangssignale eines NAND-Gatters NA, an dem ausgangsseitig das für die Ansteuerung des Transistors T4 benötigte Taktsignal mit einem vorgegebenen Puls-Pausen-Verhältnis abgenommen werden kann. In Anordnungen, die bereits einen Oszillator für eine Ladungspumpe aufweisen, ist also für die Erzeugung des Taktsignals nur ein geringer Aufwand erforderlich.

Die von der getakteten Stromquelle mit den Transistoren T1 und T4 erzeugten Ströme werden über eine Stromspiegelanordnung in eine Inverteranordnung mit den Transistoren T5 bis T8 gespiegelt. Die Transistoren T5 bis T8 sind ausgangsseitig in Reihe geschaltet und werden von der Spannungsquelle versorgt. Den eigentlichen Inverter bilden die Transistoren T6 und T7, die als komplementäre MOS-Transistoren ausgeführt sind. Dazu sind die Gates des p-Kanal-Transistors T6 und des n-Kanal-Transistors T7 miteinander und mit einem Eingang F verbunden. Den Ausgang der Inverterstufe bildet der Verbindungspunkt der Ausgangskreise der beiden Transistoren T6 und T7. Die Stromspiegelanordnung zur Einkopplung des getakteten Stroms der Stromquelle wird durch zwei Stromspiegel aus den Transistoren T3 und T5 sowie T2 und T8 gebildet. Transistor T3 ist als Diode geschaltet. Der Verbindungspunkt von Gate und Drain von T3 ist mit dem Gate von T5 verbunden. Entsprechend ist der Transistor T2 als Diode geschaltet, dessen Gate- bzw. Drainanschluß mit dem Gateanschluß des Transistors T8 verbunden ist. Mit Hilfe des durch die Stromspiegelgeometrie, d.h. die Geometrie der Transistoren T3 und T5 bzw. T2 und T8 festgelegten Übersetzungsverhältnisses wird der Strom der Stromquelle mit einem bestimmten Verhältnis in den Inverterkreis gespiegelt. Im Inverterkreis fließt gemäß der Erfindung ein geringerer Strom als von der Stromquelle erzeugt. Der Reduktionsfaktor beträgt beispielsweise 10 oder größer bezogen auf den Strom der Stromquelle. Selbstverständlich können unterschiedliche Übersetzungsverhältnisse der beiden Stromspiegel vorgesehen sein. Je nach Steuersignal an der Klemme F wird entweder der Transistor T6 oder der Transistor T7 durchgeschaltet, so daß entsprechend der Teilkreis aus den Transistoren T5 und T6 oder Teilkreis aus den Transistoren T7 und T8 Strom führt.

Am Ausgang der Inverterstufe ist ein Kondensator C gegen einen Pol der Versorgungsspannungsquelle geschaltet. Je nach Schaltzustand des Inverters wird der Kondensator C über einen getakteten und von der Stromquelle in den Inverterkreis gespiegelten sehr kleinen Strom geladen oder entladen. Wählt man als Taktverhältnis 1:10 und als Übersetzungsverhältnis der Stromspiegel 10:1, so wird der Ladestrom bzw. Entladestrom des Kondensators um den Faktor 100 gegenüber einem entsprechenden Konstantstrom, wie ihn der Transistor T1 liefert, vermindert.

Der Inverterstufe bzw. dem Verbindungspunkt der Inverterstufe mit dem Kondensator C ist ein Schmitttrigger mit den Transistoren T10 bis T13 nachgeschaltet, der ausgangsseitig den Ausgang der Verzögerungsschaltung bildet. Der Schmitttrigger schaltet sehr schnell durch, sobald sein Schaltpunkt erreicht ist. Gemäß Figur 1 wird der Schaltpunkt durch den Ladezustand des Kondensators C bestimmt. Durch den geringen Lade- bzw. Entladestrom für den Kondensator C wird die Ladezeit bis zum Schaltpunkt gegenüber einem mit Konstantstrom geladenen Kondensator entsprechend verlängert. Das bedeutet, daß der Kondensator C gegenüber einem mit Konstantstrom geladenen Kondensator entsprechend kleiner dimensioniert werden kann, um dieselbe Verzögerungszeit bis zum Schaltpunkt des Schmitttriggers zu erreichen. Neben dem kleiner zu dimensionierenden Kondensator C ermöglicht die Erfindung die Verwendung flächenminimierter Transistoren für die Inverter- bzw. Ladestufe. Ohne die Reduktion des Lade- bzw. Entladestroms müßten die Transistoren T5 bis T8 vergleichsweise lang und somit flächenintensiv gebaut werden. Die durch den Schmitttrigger gebildete Schaltstufe ermöglicht durch ihr schnelles Durchschalten die Beschleunigung der verzögerten Schaltflanke.

Im Ausführungsbeispiel gemäß Figur 1 kann sowohl die positive als auch die negative Schaltflanke über die Steuerung des Lade- bzw. Entladestroms des Kondensators gesteuert werden. Soll dagegen nur das Einschalten oder das Ausschalten alleine verzögert werden, so können die entsprechenden Stromspiegel aus den Transistoren T2 und T8 bzw. T3 und T5 weggelassen werden. Ein gemäß Figur 1 mit seinem Ausgangskreis parallel zum Kondensator C liegender Transistor T9 kann bei einem entsprechenden Eingangssignal an seinem Gateanschluß INH die Transistoren T7 und T8 überbrücken. Damit kann eine Schnellentladung des Kondensators C erreicht werden. Falls der Stromspiegel aus den Transistoren T2 und T8 nicht benötigt wird, kann auch der Transistor T9 entfallen.

## Patentansprüche

1. Analoge Verzögerungsschaltungsanordnung mit einer gesteuerten Stromquelle (T1, T4), deren Strom für den Ladezustand eines Kondensators (C) maßgebend ist, sowie mit einer Stromspiegelanordnung (T3, T5; T2, T8), einer Inverterstufe, in deren Ausgangskreis über die Stromspiegelanordnung ein von der Stromquelle abgeleiteter Strom eingekoppelt wird und die zwischen die Stromspiegelanordnung und den Kondensator geschaltet ist, und einer Schaltstufe (T10 bis T13), die mit dem Kondensator verbunden ist und an der ein Ausgangssignal abgreifbar ist,
**dadurch gekennzeichnet**, daß die Stromquelle (T1, T4) von einem Taktsignal mit einem unter 1 liegenden Puls-Pausen-Verhältnis getaktet wird und daß die Stromspiegelanordnung (T3, T5; T2, T8) den Strom der Stromquelle mit einem Stromspiegelfaktor kleiner 1 reduziert und in den Ausgangskreis der Inverterstufe (T6, T7) eingekoppelt.

2. Anordnung nach Anspruch 1,
**dadurch gekennzeichnet,**
daß die getaktete Stromquelle durch die Reihenschaltung eines als Widerstand geschalteten Transistors (T1) und eines Schalttransistors (T4) gebildet wird.

3. Anordnung nach Anspruch 1 oder 2,
**dadurch gekennzeichnet,**
daß die Stromspiegelanordnung einen Stromspiegel (T3, T5) für den Ladekreis und/oder einen Stromspiegel (T2, T8) für den Entladekreis des Kondensators enthält.

4. Anordnung nach einem der vorhergehenden Ansprüche,
**dadurch gekennzeichnet,**
daß die Schaltstufe eine dem Kondensator (C) nachgeschaltete Schmitt-Triggeranordnung (T10 bis T13) ist.

## Claims

1. Analogue delay circuit arrangement having a controlled current source (T1, T4), whose current is the governing factor for the charge state of a capacitor (C), and having a balanced circuit arrangement (T3, T5; T2, T8), an invertor stage into whose output circuit a current which is derived from the current source is coupled via the balanced circuit arrangement and which is connected between the balanced circuit arrangement and the capacitor, and a switching stage (T10 to T13) which is connected to the capacitor and on which an output signal can be picked off, characterized in that the current source (T1, T4) is pulsed by a clock signal having a pulse-pause ratio of less than 1, and in that the balanced circuit arrangement (T3, T5; T2, T8) reduces the current from the current source with a balanced circuit factor of less than 1, and couples the said current into the output circuit of the invertor stage (T6, T7).

2. Arrangement according to Claim 1, characterized in that the pulsed current source is formed by the series circuit of a transistor (T1), which is connected as a resistor, and a switching transistor (T4).

3. Arrangement according to Claim 1 or 2, characterized in that the balanced circuit arrangement contains a balanced circuit (T3, T5) for the charging circuit and/or a balanced circuit (T2, T8) for the discharging circuit of the capacitor.

4. Arrangement according to one of the preceding claims, characterized in that the switching stage is a Schmitt trigger arrangement (T10 to T13) which is connected downstream of the capacitor (C).

## Revendications

1. Circuit de retard analogique comportant une première source de courant commandée (T1, T4), dont le courant est déterminant pour l'état de charge d'un condensateur (C), un circuit miroir de courant (T3, T5 ; T2, T8) d'un étage inverseur, dans le circuit de sortie duquel un courant dérivé de la source de courant est introduit par l'intermédiaire du circuit miroir de courant et qui est branché entre le circuit miroir de courant et le condensateur, et un étage de commutation (T10 à T13), qui est relié au condensateur et auquel un signal de sortie peut être prélevé,
caractérisé par le fait que la source de courant (T1, T4) est cadencée par un signal de cadence ayant un rapport impulsions-pauses inférieur à 1 et par le fait que le circuit miroir de courant (T3, T5 ; T2, T8) réduit le courant de la source de courant d'un facteur de miroir de courant inférieur à 1 et l'introduit dans le circuit de sortie de l'étage inverseur (T6, T7).

2. Circuit selon la revendication 1,
caractérisé par le fait que
la source de courant cadencée est formée par le circuit série composé d'un transistor (T1) branché en tant que résistance et d'un transistor de commutation (T4).

3. Circuit selon la revendication 1 ou 2,
caractérisé par le fait que
le circuit miroir de courant contient un miroir de courant (T3, T5) pour le circuit de charge et/ou un miroir de courant (T2, T8) pour le circuit de décharge du condensateur.

4. Circuit selon l'une des revendications précédentes,
caractérisé par le fait que
l'étage de commutation est un circuit formant trigger de Schmitt (T10 à T13) branché en aval du condensateur (C).
